# EUROPEAN PATENT APPLICATION

(11) **EP 1 535 979 A2**
(43) Date of publication of application: **01.06.2005**
(21) Application number: 04257062.2
(22) Date of filing: 15.11.2004
(51) Int. Cl.: C09G 1/02, H01L 21/304

(54) **Compositions and methods for chemical mechanical polishing silica and silicon nitride**

(30) Priority: 26.11.2003 US 722736
(71) Applicant: Rohm and Haas Electronic Materials CMP Holdings, Inc., Wilmington, DE 19899 (US)
(72) Inventor: Mueller, Brian, Middletown, DE 19709 (US); Xu, Haofeng, Wilmington, DE 19806 (US)
(74) Representative: Buckley, Guy Julian

(57) **Abstract**

The present invention provides an aqueous composition useful for polishing silica and silicon nitride on a semiconductor wafer comprising by weight percent 0.001 to 1 phthalic acid and salts thereof, 0.001 to 1 quaternary ammonium compound, 0.01 to 5 carboxylic acid polymer, 0.01 to 5 abrasive and balance water.

## Description

### BACKGROUND OF THE INVENTION

The invention relates to chemical mechanical planarization (CMP) of semiconductor wafer materials and, more particularly, to CMP compositions and methods for polishing silica and silicon nitride from semiconductor wafers in shallow trench isolation (STI) processes.

Decreasing dimensions of devices and the increasing density of integration in microelectronic circuits have required a corresponding reduction in the size of isolation structures. This reduction places a premium on reproducible formation of structures that provide effective isolation, while occupying a minimum amount of the substrate surface.

The STI technique is a widely used semiconductor fabrication method for forming isolation structures to electrically isolate the various active components formed in integrated circuits. One major advantage of using the STI technique over the conventional LOCOS (Local Oxidation of Silicon) technique is the high scalability to CMOS (Complementary Metal-Oxide Semiconductor) IC devices for fabrication at the submicron level of integration. Another advantage is that the STI technique helps prevent the occurrence of the so-called bird's beak encroachment, which is characteristic to the LOCOS technique for forming isolation structures.

In the STI technique, the first step is the formation of a plurality of trenches at predefined locations in the substrate, usually by anisotropic etching. Next, silica is deposited into each of these trenches. The silica is then polished by CMP, down to the silicon nitride (stop layer) to form the STI structure. To achieve efficient polishing, the polishing slurry must provide a high selectivity involving the removal rate of silica relative to silicon nitride ("selectivity").

Kido et al., in U.S. Patent App. Pub. No. 2002/0045350, discloses a known abrasive composition for polishing a semiconductor device comprising a cerium oxide and a water soluble organic compound. Optionally, the composition may contain a viscosity adjusting agent, a buffer, a surface active agent and a chelating agent, although, none are specified. Although, the composition of Kido provides adequate selectivity, the ever-increasing density of integration in microelectronic circuits demand improved compositions and methods.

Hence, what is needed is a composition and method for chemical-mechanical polishing of silica and silicon nitride for shallow trench isolation processes having improved selectivity.

### STATEMENT OF THE INVENTION

In a first aspect, the present invention provides an aqueous composition useful for polishing silica and silicon nitride on a semiconductor wafer comprising by weight percent 0.001 to 1 quaternary ammonium compound, 0.001 to 1 phthalic acid and salts thereof, 0.01 to 5 carboxylic acid polymer, 0.01 to 5 abrasive and balance water.

In a second aspect, the present invention provides an aqueous composition useful for polishing silica and silicon nitride on a semiconductor wafer comprising by weight percent 0.001 to 1 tetramethyl ammonium hydroxide, 0.001 to 1 ammonium hydrogen phthalate, 0.01 to 5 polyacrylic acid, 0.01 to 5 ceria and balance water, wherein the composition has a pH of 4 to 7.

In a third aspect, the present invention provides a method for polishing silica and silicon nitride on a semiconductor wafer comprising: contacting the silica and silicon nitride on the wafer with a polishing composition, the polishing composition comprising by weight percent 0.001 to 1 quaternary ammonium compound, 0.001 to 1 phthalic acid and salts thereof, 0.01 to 5 carboxylic acid polymer, 0.01 to 5 abrasive and balance water; and polishing the silica and silicon nitride with a polishing pad.

### DETAILED DESCRIPTION OF THE INVENTION

The composition and method provide unexpected selectivity for removing silica relative to silicon nitride. The composition advantageously relies upon a chelating agent or a selectivity enhancer to selectively polish silica relative to silicon nitride for shallow trench isolation processes. In particular, the composition comprises a quaternary ammonium compound to selectively polish silica relative to silicon nitride, at the pH of the application.

The quaternary ammonium compounds of the present invention include the following structure: 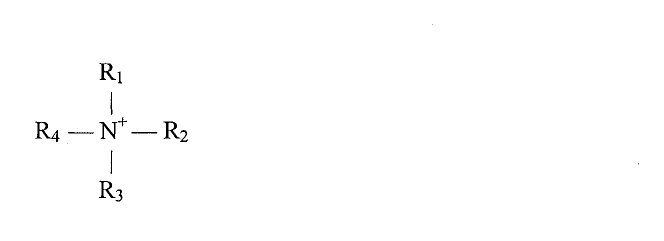 where R₁, R₂, R₃ and R₄ are an organic compound that has a carbon chain length of 1 to 15 carbon atoms. More preferably, R₁, R₂, R₃ and R₄ have a carbon chain length of 1 to 10. Most preferably, R₁, R₂, R₃ and R₄ have a carbon chain length of 1 to 5 carbon atoms. The organic compound of R₁, R₂, R₃ and R₄ may be a substituted or unsubstituted aryl, alkyl, aralkyl, or alkaryl group. Example anions include, nitrate, sulfate, halides (such as, bromide, chloride, fluoride and iodide), citrate, phosphate, oxalate, malate, gluconate, hydroxide, acetate, borate, lactate, thiocyanate, cyanate, sulfonate, silicate, per-halides (such as, perbromate, perchlorate and periodate), chromate, and mixtures comprising at least one of the foregoing anions.

Preferred quaternary ammonium compounds include, tetramethyl ammonium hydroxide, tetraethyl ammonium hydroxide, tetrapropyl ammonium hydroxide, tetraisopropyl ammonium hydroxide, tetracyclopropyl ammonium hydroxide, tetrabutyl ammonium hydroxide, tetraisobutyl ammonium hydroxide, tetratertbutyl ammonium hydroxide, tetrasecbutyl ammonium hydroxide, tetracyclobutyl ammonium hydroxide, tetrapentyl ammonium hydroxide, tetracyclopentyl ammonium hydroxide, tetrahexyl ammonium hydroxide, tetracyclohexyl ammonium hydroxide, and mixtures thereof. Most preferred quaternary ammonium compounds is tetramethyl ammonium hydroxide.

The composition advantageously contains 0.001 to 1 weight percent quaternary ammonium compound to selectively remove the silica relative to the silicon nitride. Advantageously, the composition contains 0.01 to 0.5 weight percent quaternary ammonium compound.

In addition to the quaternary ammonium compound, the composition advantageously contains 0.001 to 1 weight percent complexing agent. Advantageously, the composition contains 0.01 to 0.5 weight percent complexing agent. Example complexing agents include carbonyl compounds (e.g., acetylacetonates and the like), simple carboxylates (e.g., acetates, aryl carboxylates, and the like), carboxylates containing one or more hydroxyl groups (e.g., glycolates, lactates, gluconates, gallic acid and salts thereof, and the like), di-, tri-, and poly-carboxylates (e.g., oxalates, phthalates, citrates, succinates, tartrates, malates, edetates (e.g., disodium EDTA), mixtures thereof, and the like), carboxylates containing one or more sulfonic and/or phosphonic groups. Also, other suitable complexing agents include, for example, di-, tri-, or poly-alcohols (e.g., ethylene glycol, pyrocatechol, pyrogallol, tannic acid, and the like) and phosphate-containing compounds (e.g., phosphonium salts and phosphonic acids). Preferably, the complexing agent is phthalic acid and salts thereof. Preferred phthalate salts include, ammonium hydrogen phthalate and potassium hydrogen phthalate, and mixtures thereof.

Advantageously, the novel polishing composition contains about 0.01 to 5 weight percent of a carboxylic acid polymer. Preferably, the composition contains about 0.05 to 3 weight percent of a carboxylic acid polymer. Also, the polymer preferably has a number average molecular weight of about 20,000 to 1,500,000. In addition, blends of higher and lower number average molecular weight carboxylic acid polymers can be used. These carboxylic acid polymers generally are in solution but may be in an aqueous dispersion. The number average molecular weight of the aforementioned polymers are determined by GPC (gel permeation chromatography).

The carboxylic acid polymers are formed from unsaturated monocarboxylic acids and unsaturated dicarboxylic acids. Typical unsaturated monocarboxylic acid monomers contain 3 to 6 carbon atoms and include acrylic acid, oligomeric acrylic acid, methacrylic acid, crotonic acid and vinyl acetic acid. Typical unsaturated dicarboxylic acids contain 4 to 8 carbon atoms and include the anhydrides thereof and are, for example, maleic acid, maleic anhydride, fumaric acid, glutaric acid, itaconic acid, itaconic anhydride, and cyclohexene dicarboxylic acid. In addition, water soluble salts of the aforementioned acids also can be used.

In addition, carboxylic acid containing copolymers and terpolymers can be used in which the carboxylic acid component comprises 5-75% by weight of the polymer. Typical of such polymer are polymers of (meth)acrylic acid and acrylamide or methacrylamide; polymers of (meth)acrylic acid and styrene and other vinyl aromatic monomers; polymers of alkyl (meth)acrylates (esters of acrylic or methacrylic acid) and a mono or dicarboxylic acid, such as, acrylic or methacrylic acid or itaconic acid; polymers of substituted vinyl aromatic monomers having substituents, such as, halogen, i.e., chlorine, fluorine, bromine, nitro, cyano, alkoxy, haloalkyl, carboxy, amino, amino alkyl and a unsaturated mono or dicarboxylic acid and an alkyl (meth)acrylate; polymers of monethylenically unsaturated monomers containing a nitrogen ring, such as, vinyl pyridine, alkyl vinyl pyridine, vinyl butyrolactam, vinyl caprolactam, and an unsaturated mono or dicarboxylic acid; polymers of olefins, such as, propylene, isobutylene, or long chain alkyl olefins having 10 to 20 carbon atoms and an unsaturated mono or dicarboxylic acid; polymers of vinyl alcohol esters, such as, vinyl acetate and vinyl stearate or vinyl halides, such as, vinyl fluoride, vinyl chloride, vinylidene fluoride or vinyl nitriles, such as, acrylonitrile and methacrylonitrile and an unsaturated mono or dicarboxylic acid; polymers of alkyl (meth) acrylates having 1-24 carbon atoms in the alkyl group and an unsaturated monocarboxylic acid, such as, acrylic acid or methacrylic acid. These are only a few examples of the variety of polymers that can be used in the novel polishing composition of this invention. Also, it is possible to use polymers that are biodegradeable, photodegradeable or degradeable by other means. An example of such a composition that is biodegradeable is a polyacrylic acid polymer containing segments of poly(acrylate comethyl 2-cyanoacrylate).

Advantageously, the polishing composition contains 0.01 to 5 weight percent abrasive to facilitate silica removal. Within this range, it is desirable to have the abrasive present in an amount of greater than or equal to 0.1 weight percent. Also, desirable within this range is an amount of less than or equal to 3 weight percent.

The abrasive has an average particle size between 50 to 200 nanometers (nm). For purposes of this specification, particle size refers to the average particle size of the abrasive. More preferably, it is desirable to use an abrasive having an average particle size between 80 to 150 nm. Decreasing the size of the abrasive to less than or equal to 80 nm, tends to improve the planarization of the polishing composition, but, it also tends to decrease the removal rate.

Example abrasives include inorganic oxides, inorganic hydroxides, metal borides, metal carbides, metal nitrides, polymer particles and mixtures comprising at least one of the foregoing. Suitable inorganic oxides include, for example, silica (SiO₂), alumina (Al₂O₃), zirconia (ZrO₂), ceria (CeO₂), manganese oxide (MnO₂), or combinations comprising at least one of the foregoing oxides. Modified forms of these inorganic oxides, such as, polymer-coated inorganic oxide particles and inorganic coated particles may also be utilized if desired. Suitable metal carbides, boride and nitrides include, for example, silicon carbide, silicon nitride, silicon carbonitride (SiCN), boron carbide, tungsten carbide, zirconium carbide, aluminum boride, tantalum carbide, titanium carbide, or combinations comprising at least one of the foregoing metal carbides, boride and nitrides. Diamond may also be utilized as an abrasive if desired. Alternative abrasives also include polymeric particles and coated polymeric particles. The preferred abrasive is ceria.

The compounds provide efficacy over a broad pH range in solutions containing a balance of water. This solution's useful pH range extends from at least 4 to 7. In addition, the solution advantageously relies upon a balance of deionized water to limit incidental impurities. The pH of the polishing fluid of this invention is preferably from 4.5 to 6.8, more preferably a pH of 5 to 6.5. The acids used to adjust the pH of the composition of this invention are, for example, nitric acid, sulfuric acid, hydrochloric acid, phosphoric acid and the like. Exemplary bases used to adjust the pH of the composition of this invention are, for example, ammonium hydroxide and potassium hydroxide.

Accordingly, the present invention provides a composition useful for polishing silica and silicon nitride on a semiconductor wafer for shallow trench isolation processes. The composition advantageously comprises quaternary ammonium compounds for improved selectivity. In particular, the present invention provides an aqueous composition useful for polishing silica and silicon nitride on a semiconductor wafer comprising quaternary ammonium compound, phthalic acid and salts thereof, carboxylic acid polymer, abrasive and balance water. The composition exhibits particularly improved selectivity at a pH range of 4 to 7.

### Examples

In the Examples, numerals represent examples of the invention and letters represent comparative examples. All example solutions contained, by weight percent, 1.8 ceria, 0.18 polyacrylic acid and 0.21 ammonium hydrogen phthalate.

### Example 1

This experiment measured the selectivity of silica relative to silicon nitride on a semiconductor wafer. In particular, the effect of quaternary ammonium compounds on selectivity of silica relative to silicon nitride was tested. An IPEC 472 DE 200mm polishing machine using an IC1000™ polyurethane polishing pad (Rodel, Inc.) under downforce conditions of about 5 psi and a polishing solution flow rate of 150 cc/min, a platen speed of 52 RPM and a carrier speed of 50 RPM planarized the samples. The polishing solutions had a pH of 6 and 7 (Examples 1 and 2, respectively) adjusted with nitric acid. All solutions contained deionized water.

**Table 1**

| Test | Abrasive (wt.%) | TMAH (wt.%) | PAA (wt.%) | AHP (wt.%) | pH | TEOS (Å/min) | SiN (Å/min) | Selectivity |
|---|---|---|---|---|---|---|---|---|
| A | 1.8 | 0.04 | 0.18 | 0.21 | 6 | 2645 | 128 | 21 |
| 1 | 1.8 | 0.12 | 0.18 | 0.21 | 6 | 3052 | 127 | 24 |

As illustrated in Table 1 above, the addition of the quaternary ammonium compound improved the selectivity of the composition. In particular, the addition of the tetramethyl ammonium hydroxide improved the selectivity of the composition of Test 1 for the TEOS relative to the silicon nitride from 21 (Test A) to 24. Note, the modest selectivity increase is the result, at least, of the 0.04 weight percent tetramethyl ammonium hydroxide present in Test A, which increased the removal rate of the TEOS.

### Example 2

In this example, the concentration of the tetramethyl ammonium hydroxide was increased to 0.18 weight percent. Test B did not contain any tetramethyl ammonium hydroxide. Also, the pH was increased to 7. All other parameters were the same as those of Example 1.

**Table 2**

| Test | Abrasive (wt. %) | TMAH (wt.%) | PAA (wt.%) | AHP (wt.%) | pH | TEOS (Å/min) | SiN (Å/min) | Selectivity |
|---|---|---|---|---|---|---|---|---|
| B | 1.8 | -- | 0.18 | 0.21 | 7 | 2637 | 107 | 25 |
| 2 | 1.8 | 0.18 | 0.18 | 0.21 | 7 | 3284 | 53 | 62 |

As illustrated in Table 2 above, the increased concentration of tetramethyl ammonium hydroxide provides improved selectivity values. In particular, Test 2 provided a selectivity of 62 compared to 25 for Test B. Note, the selectivity was markedly improved from that of Test B, which did not contain any tetramethyl ammonium hydroxide (compare to Example 1 above, which contained tetramethyl ammonium hydroxide in the comparative example). In addition, the increase in pH to 7 from 6 (Example 1) shows an improvement in the selectivity.

Accordingly, the present invention provides a composition useful for polishing silica and silicon nitride on a semiconductor wafer for shallow trench isolation processes. The composition advantageously comprises quaternary ammonium compounds for improved selectivity during the polishing process. In particular, the present invention provides an aqueous composition useful for polishing silica and silicon nitride on a semiconductor wafer comprising quaternary ammonium compound, phthalic acid and salts thereof, carboxylic acid polymer, abrasive and balance water.

## Claims

1. An aqueous composition useful for polishing silica and silicon nitride on a semiconductor wafer comprising by weight percent 0.001 to 1 quaternary ammonium compound, 0.001 to 1 phthalic acid and salts thereof, 0.01 to 5 carboxylic acid polymer, 0.01 to 5 abrasive and balance water.

2. The composition of claim 1 wherein the quaternary ammonium compound is selected from the group comprising: tetramethyl ammonium hydroxide, tetraethyl ammonium hydroxide, tetrapropyl ammonium hydroxide, tetraisopropyl ammonium hydroxide, tetracyclopropyl ammonium hydroxide, tetrabutyl ammonium hydroxide, tetraisobutyl ammonium hydroxide, tetratertbutyl ammonium hydroxide, tetrasecbutyl ammonium hydroxide, tetracyclobutyl ammonium hydroxide, tetrapentyl ammonium hydroxide, tetracyclopentyl ammonium hydroxide, tetrahexyl ammonium hydroxide, tetracyclohexyl ammonium hydroxide, and mixtures thereof

3. The composition of claim 1 wherein the phthalate salt is selected from the group comprising: ammonium hydrogen phthalate and potassium hydrogen phthalate.

4. The composition of claim 1 wherein the abrasive is ceria.

5. The composition of claim 4 wherein the ceria has an average particle size of between 50-200 nm.

6. The composition of claim 5 wherein the ceria has an average particle size of between 80-150 nm.

7. The composition of claim 1 wherein the aqueous composition has a pH of 4 to 7.

8. An aqueous composition useful for polishing silica and silicon nitride on a semiconductor wafer comprising by weight percent 0.001 to 1 tetramethyl ammonium hydroxide, 0.001 to 1 ammonium hydrogen phthalate, 0.01 to 5 polyacrylic acid, 0.01 to 5 ceria and balance water, wherein the composition has a pH of 4 to 7.

9. A method for polishing silica and silicon nitride on a semiconductor wafer comprising:
contacting the silica and silicon nitride on the wafer with a polishing composition, the polishing composition comprising by weight percent 0.001 to 1 quaternary ammonium compound, 0.001 to 1 phthalic acid and salts thereof, 0.01 to 5 carboxylic acid polymer, 0.01 to 5 abrasive and balance water; and
polishing the silica and silicon nitride with a polishing pad.

10. The method of claim 9 wherein the quaternary ammonium compound is selected from the group comprising: tetramethyl ammonium hydroxide, tetraethyl ammonium hydroxide, tetrapropyl ammonium hydroxide, tetraisopropyl ammonium hydroxide, tetracyclopropyl ammonium hydroxide, tetrabutyl ammonium hydroxide, tetraisobutyl ammonium hydroxide, tetratertbutyl ammonium hydroxide, tetrasecbutyl ammonium hydroxide, tetracyclobutyl ammonium hydroxide, tetrapentyl ammonium hydroxide, tetracyclopentyl ammonium hydroxide, tetrahexyl ammonium hydroxide, tetracyclohexyl ammonium hydroxide, and mixtures thereof.
